# EUROPEAN PATENT APPLICATION

(11) **EP 4 516 962 A1**
(43) Date of publication of application: **05.03.2025**
(21) Application number: 23858860.2
(22) Date of filing: 27.06.2023
(51) Int. Cl.: C23C 16/44

(54) **TEMPERATURE CONTROL COMPONENT AND CVD REACTION DEVICE**

(30) Priority: 29.08.2022 CN 202211043209
(71) Applicant: Advanced Micro-Fabrication Equipment Inc. China, Shanghai 201201 (CN)
(72) Inventor: ZHENG, Zhenyu, Shanghai 201201 (CN); CHEN, Danying, Shanghai 201201 (CN); JIANG, Yong, Shanghai 201201 (CN); ZHOU, Ning, Shanghai 201201 (CN)
(74) Representative: Sanger, Phillip Simon
(86) International application number: PCT/CN2023/102788
(87) International publication number: WO 2024/045822

(57) **Abstract**

Disclosed in the present invention are a temperature control component and a chemical vapor deposition (CVD) reaction apparatus. The apparatus includes a chamber; a shower head provided at the top of the chamber and configured to introduce a reaction gas for growing a thin film into the chamber; and a susceptor provided at the bottom of the chamber, disposed opposite to the shower head and configured to carry a substrate, wherein the chamber further includes a liner located inside the chamber and disposed around an inner side wall of the chamber; a side heater provided close to the inner side wall of the chamber, located above the susceptor and configured to heat the reaction gas in the chamber; and a temperature control component provided inside the chamber and located above the susceptor, and the temperature control component emits heat to heat the reaction gas in a central area of the chamber. The present invention can reduce a radial temperature gradient along a radial direction inside the chamber.

## Description

### TECHNICAL FIELD

The present invention relates to the technical field of semiconductor processing equipment, and particularly relates to a temperature control component and a chemical vapor deposition (CVD) reaction apparatus.

### BACKGROUND

An existing vapor-phase epitaxial growth apparatus, such as a chemical vapor deposition (CVD) apparatus, includes a furnace body or a chamber; a chamber top cover provided at the top of the chamber, wherein a shower head is provided on the chamber top cover and configured to introduce a reaction gas for growing a thin film into the chamber; a susceptor provided at the bottom of the chamber and disposed opposite to the shower head, wherein the susceptor is provided with a carrying surface for carrying a substrate, a lower heater is further provided below the carrying surface and configured to heat the substrate so that the substrate can meet a temperature condition under which the thin film can grow thereon; and a side heater provided close to an inner side wall of the chamber and configured to heat the reaction gas located in the chamber.

Heaters of the vapor-phase epitaxial growth apparatus include the lower heater located at the bottom of the chamber and a side wall heater located on a side wall, accordingly, which causes a lower temperature of the reaction gas located at an inlet of the apparatus. At the same time, due to the presence of the side wall heater, the temperature of the side wall is higher, the temperature has a big radial temperature difference along a radial direction, which will result in a natural convection caused by buoyancy, thereby causing a certain reflux (vortex) to exist on the hot side wall. Due to a high temperature of the hot side wall, for example, when a SiC film is prepared, after a carbon source and a silicon source are decomposed, a decomposition product is carried by a vortex to the vicinity of the side wall and the top cover, causing SixCy deposition, increasing the loss of the carbon source and the silicon source, influencing the ratio of C/Si above the substrate, and making a reaction condition uncontrollable.

In addition, a high temperature gradient above the substrate makes main reaction components very sensitive to temperature fluctuations, which may cause unstable growth conditions of a thin film grown on the substrate, thereby causing variations in thickness uniformity and doping uniformity of the formed thin film.

### DISCLOSURE OF THE INVENTION

An object of the present invention is to provide a temperature control component and a chemical vapor deposition (CVD) reaction apparatus, so as to solve the problem that a radial temperature gradient along a radial direction inside a chamber is too large, and along an axial direction of the chambera large axial temperature gradient results in uncontrollable film formation conditions and poor uniformity in film thickness and doping.

To solve the above problem, the present invention is realized by the following technical solution:

a CVD reaction apparatus comprises a chamber; a shower head 201 provided at the top of the chamber and configured to introduce a reaction gas for growing a thin film into the chamber; and a susceptor 400 provided at the bottom of the chamber, disposed opposite to the shower head 201 and configured to carry a substrate 700, wherein the chamber further comprises a liner located inside the chamber and disposed around an inner side wall of the chamber; a side heater 601 provided close to the inner side wall of the chamber, located above the susceptor 400 and configured to heat the reaction gas in the chamber; and a temperature control component 500 provided inside the chamber and located above the susceptor 400, wherein the temperature control component 500 emits heat to heat the reaction gas in a central area of the chamber.

Optionally, the temperature control component 500 is coaxially arranged with the chamber, and a lengthwise annular gas flow passage is formed between an outer side wall of the temperature control component 500 and the liner.

Optionally, the temperature control component 500 is fixedly connected with the chamber via a connecting member 510, and the connecting member 510 is located at one end of the temperature control component 500 close to the shower head 201.

Optionally, the liner comprises an upper liner 301 and a lower liner 302, the lower liner 302 is provided at the periphery of the susceptor 400, the upper liner 301 is located above the lower liner 302, and the side heater 601 is located between the upper liner 301 and the inner side wall of the chamber; and the temperature control component 500 is connected to the upper liner 301 via the connecting piece 510.

Optionally, the connecting member 510 comprises an annular portion 511 and a plurality of connecting bars 512, and the plurality of connecting bars 512 are provided at intervals around the temperature control component 500; one end of each of the connecting bars 512 is connected to the temperature control component 500, and the other end of each of the connecting bars is connected to the annular portion 511; and the annular portion 511 laps over the upper liner 301.

Optionally, the annular portion 511, the plurality of connecting bars 512 and the temperature control component 500 are integrally provided.

Optionally, the CVD reaction apparatus further comprises a lower heater 600 provided inside the susceptor 400 and configured to heat the substrate 700.

Optionally, the heat absorption rate of the temperature control component 500 is greater than the heat absorption rate of the reaction gas.

Optionally, the temperature control component 500 and the connecting member 510 are prepared from at least one of graphite, silicon carbide, tantalum carbide or high-temperature-resistant metals such as tungsten, molybdenum and tantalum.

Optionally, silicon carbide and/or tantalum carbide coatings are provided on surfaces of the temperature control component 500 and the connecting member 510.

Optionally, the temperature control component 500 is a heat absorption rod and extends along an axial direction of the chamber, and the heat absorption rod is configured to absorb heat emitted by the lower heater 600 and the side heater 601 and emit the absorbed heat to the central area of the chamber to heat the reaction gas located in the central area of the chamber.

Optionally, the heat absorption rod is integrally in the shape of a spindle body.

Optionally, the diameter of the heat absorption rod is less than 1/2 of the diameter of the substrate 700.

Optionally, the length of the heat absorption rod is greater than 1/2 of the length of the upper liner 301.

Optionally, the distance between an end portion of one end of the heat absorption rod close to the substrate 700 and the substrate 700 is 20 mm-100 mm.

Optionally, the temperature control component 500 is a heat absorption hollow cylinder and extends along the axial direction of the chamber, and the heat absorption hollow cylinder is configured to absorb heat emitted by the lower heater 600 and the side heater 601 and emit the absorbed heat to the central area of the chamber to heat the reaction gas located in the central area of the chamber.

Optionally, the diameter of the heat absorption hollow cylinder is greater than the diameter of the substrate 700 and less than the inner diameter of the upper liner 301.

Optionally, the length of the heat absorption hollow cylinder is greater than 1/2 of the length of the upper liner 301.

Optionally, the distance between an end portion of one end of the heat absorption hollow cylinder close to the substrate 700 and the substrate 700 is 20 mm-100 mm.

Optionally, the temperature control component 500 comprises: a heating main body 50; a heater 51 provided inside the heating main body 50; and a controller 53 located outside the chamber and connected to the heater 51, wherein the controller 53 controls the heater 51 to heat the central area of the chamber.

Optionally, the heater 51 comprises a heating wire 52 which penetrates through the connecting member 510 and is led to the outside of the chamber.

Optionally, the CVD reaction apparatus further comprises a top cover 200 provided at the top of the chamber, wherein the shower head 201 is provided on the top cover 200.

In another aspect, the present invention further provides a temperature control component, which is applied in a chamber of a CVD reaction apparatus, wherein the temperature control component comprises a heating main body and a connecting member, the heating main body is provided inside the chamber and configured to heat a reaction gas in a central area of the chamber, and the connecting member is configured to implement a connection between the heating main body and the chamber.

Optionally, the heating main body is coaxially arranged with the chamber.

Optionally, the connecting member comprises an annular portion and a plurality of connecting bars, wherein the plurality of connecting bars are provided at intervals around the heating main body; one end of each of the connecting bars is connected to the heating main body, and the other end of each of the connecting bars is connected to the annular portion; and the annular portion is fixedly connected to the chamber.

Optionally, the heating main body is a heat absorption rod and extends along the axial direction of the chamber; and the heat absorption rod is configured to absorb heat emitted by the lower heater and the side heater both provided in the CVD reaction apparatus and emit the absorbed heat to the central area of the chamber to heat the reaction gas located in the central area of the chamber.

Optionally, the heat absorption rod is integrally in the shape of a spindle body.

Optionally, the heating main body is a heat absorption hollow cylinder and extends along the axial direction of the chamber; and the heat absorption hollow cylinder is configured to absorb heat emitted by the lower heater and the side heater both provided in the CVD reaction apparatus and emit the absorbed heat to the central area of the chamber to heat the reaction gas located in the central area of the chamber.

Optionally, the diameter of the heat absorption hollow cylinder is greater than or equal to the diameter of the substrate treated in the CVD reaction apparatus.

Optionally, the heat absorption rate of the heating main body is greater than the heat absorption rate of the reaction gas.

Optionally, the heating main body and the connecting member are prepared from at least one of graphite, silicon carbide, tantalum carbide or high-temperature-resistant metals such as tungsten, molybdenum and tantalum.

Optionally, silicon carbide and/or tantalum carbide coatings are provided on surfaces of the heating main body and the connecting member.

Optionally, the temperature control component further comprises: a heater provided inside the heating main body; and a controller located outside the chamber and connected to the heater, wherein the controller controls the heater to heat the central area of the chamber.

The present invention at least has one of the following advantages:

The reaction gas in the central area of the chamber is heated via the temperature control component provided in the CVD reaction apparatus provided in the present invention, so that a radial temperature gradient along the radial direction inside the chamber is reduced, and the problem that a gas in an area close to the side heater has a higher temperature and is likely to flow upward, and the gas in the central area has a lower temperature and is likely to flow downward to form a gas vortex above the substrate is solved, thereby reducing by-product deposition on the side wall (which specifically refers to side walls of the upper liner and the lower liner) and shower head fittings, increasing the utilization rate of a reaction gas source and prolonging the maintenance period of the side walls of the upper liner and the lower liner and the shower head.

Through the temperature control component, the temperature gradient over the substrate can also be reduced, so that the growth condition of the substrate is more stable, thereby improving the thickness uniformity and doping uniformity of the thin film grown on the whole substrate.

The heat absorption rod is integrally in the shape of a spindle body, and the heat absorption rod in such a shape does not influence the flow direction and distribution of the reaction gas in the central area, thus facilitating the growth condition of the substrate to remain stable.

The heat absorption hollow cylinder is in the shape of a hollow cylinder. The reaction gas in the central area can pass through the center of the heat absorption hollow cylinder to flow toward the surface of the substrate, thereby facilitating the growth condition of the substrate to remain stable. In some embodiments, the diameter (which may specifically refer to the inner diameter) of the heat absorption hollow cylinder is set to be greater than the diameter of the substrate, which can prevent particle contaminants that may exist on the heat absorption hollow cylinder from falling onto the surface of the substrate, thereby further improving the quality of the substrate.

### BRIEF DESCRIPTION OF THE DRAWINGS

FIG. 1 is a main structural schematic view of a CVD reaction apparatus according to an embodiment of the present invention;
FIG. 2 is a main structural schematic view of a temperature control component as a heat absorption rod according to an embodiment of the present invention;
FIG. 3 is a main structural schematic view of a temperature control component as a heat absorption rod having four connecting bars according to an embodiment of the present invention;
FIG. 4 is a main structural schematic view of a CVD reaction apparatus according to another embodiment of the present invention;
FIG. 5 is a main structural schematic view of a temperature control component as a heat absorption hollow cylinder according to an embodiment of the present invention;
FIG. 6 is a main structural schematic view of a temperature control component as a heat absorption hollow cylinder having four connecting bars according to an embodiment of the present invention; and
FIG. 7 is a main structural schematic view of a temperature control component provided in a CVD reaction apparatus and serving as an active heating element according to an embodiment of the present invention.

### BEST IMPLEMENTATIONS OF THE INVENTION

A temperature control component and a chemical vapor deposition (CVD) reaction device provided in the present invention will be described in further detail in conjunction with the accompanying drawings and the specific embodiments. The advantages and features of the present invention will become more apparent from the following description. It should be noted that all the drawings are in very simplified form and use imprecise scales, which are only used to facilitate and assist the purpose of clearly illustrating the embodiments of the present invention. In order to make the objects, features and advantages of the present invention more comprehensible, please refer to the accompanying drawings. It should be noted that the structures, scales, sizes, etc. shown in the drawings attached to this specification are only used to match the content disclosed in the specification, for those who are familiar with this technology to understand and read, and are not used to limit the limiting conditions of the implementation of the present invention. It does not have any technical substantive significance, and any structural modification, change in proportional relationship, or size adjustment should still fall within the scope covered by the technical content disclosed in the present invention without affecting the effect and purpose of the present invention.

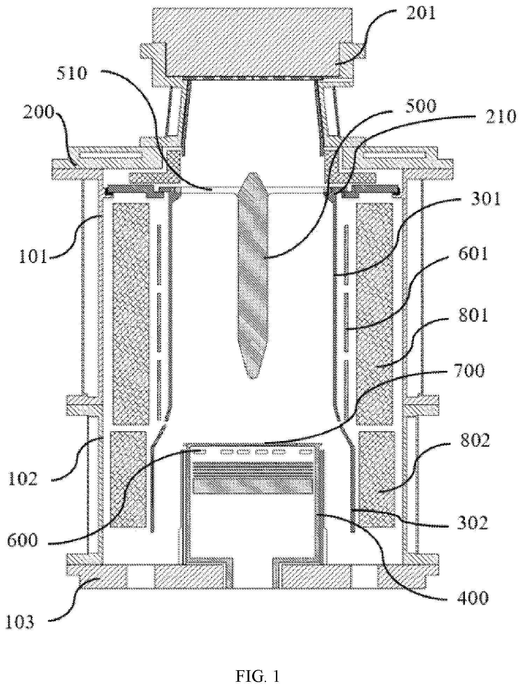

As shown in FIG. 1, a CVD reaction apparatus is provided in this embodiment, including a chamber, wherein in the present embodiment, the chamber includes an upper chamber 101 and a lower chamber 102, the upper chamber 101 is located on the lower chamber 102, and inner areas of the upper chamber and the lower chamber communicate with each other to form a reaction space; a top cover 200 provided at the top of the chamber and specifically disposed at the top of the upper chamber 101; a shower head 201 provided on the top cover 200 and configured to introduce a reaction gas for growing a thin film into the chamber, wherein in this embodiment, a housing (not shown in the figure) may be disposed outside the top cover 200 to realize sealing of the top cover and the chamber; and a susceptor 400 provided at the bottom of the lower chamber 102, disposed opposite to the shower head 201 and configured to carry a substrate 700.

This embodiment further includes a chamber liner, which is located inside the chamber and disposed around an inner side wall of the chamber, wherein the chamber liner includes an upper liner 301 and a lower liner 302, the lower liner 302 is located at the periphery of the susceptor 400, the upper liner 301 is located above the lower liner 302 and configured to protect an inner side wall of the upper chamber 101 against contamination. The lower liner 302 can move between a process position and a substrate picking and releasing position. When the substrate is picked and released, the lower liner 302 is located at the substrate picking and releasing position, a manipulator passes through a substrate picking opening of the chamber and passes by an upper edge of the lower liner to pick and release the substrate and/or a base under the substrate. After the substrate is released, the manipulator moves out, the lower liner 302 moves upward to the process position to shield the substrate picking opening, thereby ensuring the uniformity of a circumferential temperature of the substrate.

A side heater 601 is located between the upper liner 301 and the inner side wall of the upper chamber 101, is located above the susceptor 400, and is configured to heat the reaction gas located in the chamber (which specifically refers to the chamber liner), and specifically configured to mainly heat the reaction gas (in this embodiment, which specifically refers to the reaction gas in the inner area of the upper liner 301) located in the inner area of the upper chamber 101.

An upper thermal insulator 801 is disposed between the side heater 601 and the upper chamber 101. Since the CVD reaction apparatus needs a high temperature, the side heater 601 needs to provide a high heating temperature, for example, over 1000 °C. In the present invention, the upper thermal insulator is disposed between the side heater and the upper chamber 101, so that the heat of the side heater can be effectively limited inside the chamber, and the heat loss inside the chamber is reduced while the safety of equipment is ensured.

A lower thermal insulator 802 is disposed between the lower chamber 102 and the lower liner 302. Since the CVD reaction apparatus needs a high temperature, a lower heater 600 needs to provide a high heating temperature, for example, over 1000 °C. In the present invention, the lower thermal insulator 802 is disposed between the lower chamber 102 and the lower liner 302, so that the heat of the side heater can be effectively limited inside the chamber, and the heat loss inside the chamber is reduced while the safety of equipment is ensured.

The lower heater 600 is provided inside the susceptor 400 and configured to heat the substrate 700.

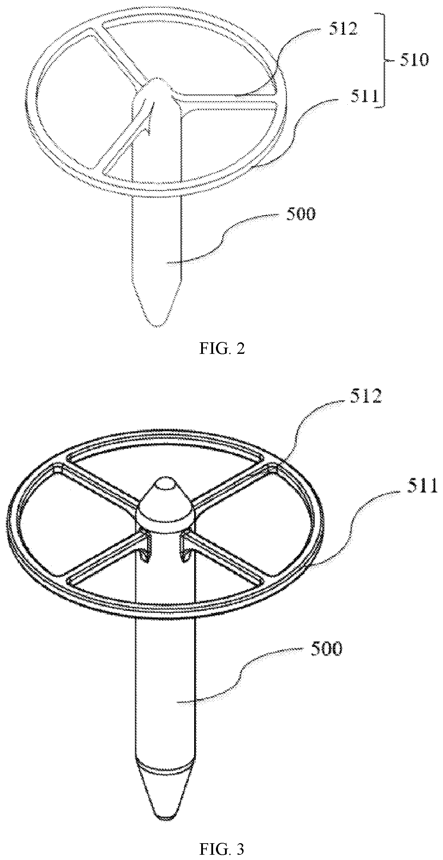

As shown in FIG. 1 and FIG. 2, this embodiment further includes a temperature control component 500 disposed inside the chamber and located above the susceptor 400, wherein the temperature control component 500 is configured to emit heat to heat the reaction gas in a central area of the chamber (which specifically refers to the chamber liner).

In this embodiment, the reaction gas in the central area of the chamber (which specifically refers to the chamber liner) is heated via the temperature control component, so that a radial temperature gradient along the present disclosure radial direction inside the chamber (which specifically refers to the chamber liner) is reduced, and the problem that a gas in an area close to the side heater 601 has a higher temperature and is likely to flow upward, and the gas in the central area has a lower temperature and is likely to flow downward to form a gas vortex above the substrate 700 is solved, thereby reducing by-product deposition on the side wall (which specifically refers to side walls of the upper liner 301 and the lower liner 302) and shower head fittings, increasing the utilization rate of a reaction gas source, and prolonging the maintenance period of the side walls of the upper liner 301 and the lower liner 302 and the shower head. Through the temperature control component, the temperature gradient of different areas above the substrate can also be reduced, so that the growth condition of the substrate is more stable, thereby improving the thickness uniformity and doping uniformity of the film grown on the substrate.

Continuously referring to FIG. 1, in this embodiment, the temperature control component 500 is coaxially arranged with the chamber (which specifically refers to being coaxially arranged with the chamber liner). Thus, the distance between a surface of the temperature control component 500 and a side wall of the upper liner 301 is equal. In this way, the reaction gas in the central area of the chamber (which specifically refers to the chamber liner) can be further heated uniformly, and thus the radial temperature gradient along the radial direction inside the chamber (which specifically refers to the chamber liner) can be better adjusted.

Continuously referring to FIG. 1 and FIG. 2, in this embodiment, the temperature control component 500 is fixedly connected to the chamber via a connecting member 510, and specifically, the temperature control component 500 may be connected to the upper liner 301 via the connecting member 510.

It can be understood that in this embodiment, a flange 210 is provided between the upper chamber 101 and the top cover 200, and the upper liner 301 is hung on the flange 210, so the annular portion 511 can overlap the flange 210. However, the present invention is not limited thereto, in other embodiments, the connecting member 510 may also be directly connected to the upper liner 301 or the top cover 200.

Continuously referring to FIG. 2, the annular portion 511 included in the connecting member 510 laps over the upper liner 301 or the flange 210. In this embodiment, the number of the connecting bars 512 is three, and the three connecting bars are disposed in central symmetry. Alternatively, as shown in FIG. 3, the number of the connecting bars 512 may be four, and the four connecting bars 512 are disposed in central symmetry.

It can be understood that the number of the connecting bars 512 is not limited thereto. Alternatively, the number of the connecting bars 512 may be greater than or equal to 2, as long as the temperature control component 500 can be fixed without affecting the uniformity of the reaction gas transmitted to the surface of the substrate.

In this embodiment, the heat absorption rate of the temperature control component 500 is greater than the heat absorption rate of the reaction gas. Thus, radiation heat emitted by the side heater 601 can be greatly absorbed by the temperature control component 500, and then the absorbed heat is radiated to the surroundings, so that the reaction gas around the temperature control component 500 can be heated. In this embodiment, the temperature control component 500 and the connecting member 510 are prepared from graphite. In another embodiment, the temperature control component 500 and the connecting member 510 may be prepared from silicon carbide, tantalum carbide or high-temperature-resistant metals such as tungsten, molybdenum, tantalum and the like. According to different processes of different CVD reaction apparatuses, when selecting a material for the temperature control component, it is necessary to ensure that a process gas does not react with the surface of the temperature control component.

**In** this embodiment or other embodiments, high-temperature-resistant coatings such as silicon carbide and/or tantalum carbide coatings and the like are provided on surfaces of the temperature control component 500 and connecting member 510. **In** this case, host materials of the temperature control component 500 and the connecting member 510 may be graphite or high-temperature-resistant metals. By providing the high-temperature-resistant coatings such as silicon carbide and/or tantalum carbide coatings on the surface of the host materials, the cost of the temperature control component can be reduced, and at the same time, the host materials are protected against possible damage caused by the process gas.

In the same embodiment, the temperature control component 500 and the connecting member 510 may be prepared from the same materials or different materials, which is not specifically limited herein.

Continuously referring to FIG. 1, in this embodiment, the temperature control component 500 is a heat absorption rod that extends along an axial direction of the chamber (which specifically refers to the chamber liner), wherein the heat absorption rod is configured to absorb heat emitted by the lower heater 600 and the side heater 601 and emit the absorbed heat to the central area of the chamber (which specifically refers to the chamber liner) to heat the reaction gas located in the central area of the chamber (which specifically refers to the chamber liner).

In this embodiment, the heat absorption rod is in the shape of a spindle body, and the diameter of the heat absorption rod is less than 1/2 of the diameter of the substrate 700. The heat absorption rod in such a shape does not influence the flow direction and distribution of the reaction gas in the central area, thus facilitating the growth condition of the substrate to remain stable. Preferably, in this embodiment, the diameter of the heat absorption rod is 30 mm. However, the present invention is not limited thereto.

In this embodiment, the length of the heat absorption rod is greater than 1/2 of the length of the upper liner 301. Thus, the reaction gas in a whole area surrounded by the upper liner 301 can be heated, thereby further facilitating reducing the radial temperature gradient along the radial direction inside the chamber (which specifically refers to the chamber liner). Preferably, in this embodiment, the length of the heat absorption rod is 275 mm. However, the present invention is not limited thereto.

The distance between an end portion of one end of the heat absorption rod close to the substrate 700 and the substrate 700 is 20 mm-100 mm. When the distance is greater than 20 mm, it can ensure that the heat absorption rod does not affect the picking and releasing of the substrate 700 by an external manipulator. When the distance is less than 100 mm, it can ensure that the bottom and a side wall of the heat absorption rod can heat the reaction gas in the central area close to an area of the substrate 700, avoiding a low temperature spot inside the chamber (which specifically refers to the chamber liner), thereby ensuring the heating uniformity of the substrate 700. Accordingly, the temperature gradient (the axial temperature gradient of the chamber) above the substrate 700 can be avoided, so that the growth condition of the substrate 700 is more stable, thereby improving the thickness uniformity and doping uniformity. Preferably, in this embodiment, the distance between an end portion of one end of the heat absorption rod close to the substrate 700 and the substrate 700 is 50 mm. However, the present invention is not limited thereto.

In this embodiment, the annular portion 511, the plurality of connecting bars 512 and the heat absorption rod are integrally provided to facilitate replacing the temperature control component 500. In another embodiment, the annular portion, the connecting bars and the heat absorption rod may also be manufactured separately and then connected and fixed in a mechanical or welding manner. The present invention does not limit a connection manner thereof. Despite a simple structure, the temperature control component 500 in this embodiment can solve the problem that a radial temperature gradient of the reaction gas along a radial direction inside the chamber (which specifically refers to the chamber liner) is too large, and along an axial direction of the chamber (which specifically refers to the chamber liner), a large axial temperature gradient results in uncontrollable film formation conditions and poor uniformity in film thickness and doping.

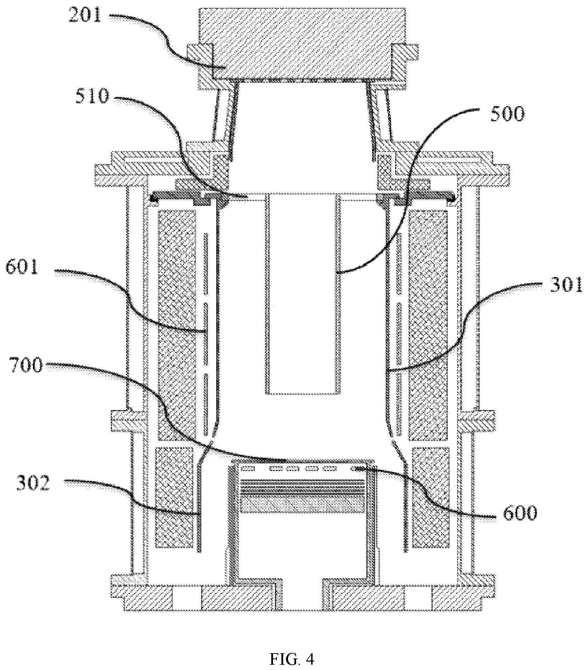

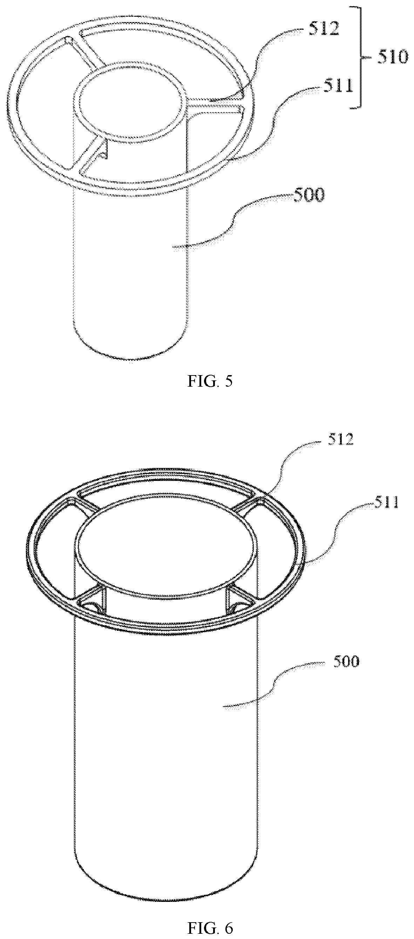

Referring to some other embodiments shown in FIG. 4 and FIG. 5, in this embodiment, the temperature control component 500 may be a heat absorption hollow cylinder that extends along the axial direction of the chamber (which specifically refers to the chamber liner), wherein the heat absorption hollow cylinder is configured to absorb heat emitted by the lower heater 600 and the side heater 601 provided in the CVD reaction apparatus and emit the absorbed heat to the central area of the chamber (which specifically refers to the chamber liner) to heat the reaction gas located in the central area of the chamber (which specifically refers to the chamber liner).

The heat absorption hollow cylinder has openings at two ends and is internally hollow. The heat absorption hollow cylinder is hollow and cylindrical. The reaction gas in the central area can pass through the center of the heat absorption hollow cylinder to flow toward the surface of the substrate, so as to reduce the influence of the heat absorption hollow cylinder on a gas flow inside the chamber (which specifically refers to the chamber liner), thereby facilitating the growth condition of the substrate to remain stable.

In an embodiment, the diameter of the heat absorption hollow cylinder is greater than or equal to the diameter of the substrate 700 and less than the inner diameter of the upper liner 301. Optionally, in this embodiment, the diameter of the heat absorption hollow cylinder is 180 mm. The heat absorption hollow cylinder in such a shape can better reduce the distribution of the radial temperature gradient of the reaction gas in the chamber (which specifically refers to the chamber liner). At the same time, when the diameter of the heat absorption hollow cylinder is greater than the diameter of the substrate, deposit sediments possibly formed on inner and outer cylinder walls of the heat absorption hollow cylinder cannot fall onto the surface of the substrate, thereby facilitating improving the film growth quality of the substrate. Meanwhile, the diameter of the heat absorption hollow cylinder should not be too large. Due to a low temperature of the reaction gas close to the central area of the chamber (which specifically refers to the chamber liner), if the diameter of the heat absorption hollow cylinder is too large, the heating effect of the heat absorption hollow cylinder on the reaction gas in the central area of the chamber (which specifically refers to the chamber liner) will become insignificant. Thus, the technical problem to be solved by the present embodiment might not be solved.

In this embodiment, the length of the heat absorption hollow cylinder is greater than 1/2 of the length of the upper liner 301. Thus, the reaction gas in the whole area surrounded by the upper liner 301 can be heated, thereby further facilitating reducing the radial temperature gradient along the radial direction inside the chamber (which specifically refers to the chamber liner). Preferably, in this embodiment, the length of the heat absorption hollow cylinder is 330 mm. However, the present invention is not limited thereto. Essentially, the length of the heat absorption hollow cylinder can be adjusted as required according to the size of the chamber (which specifically refers to the chamber liner).

In this embodiment, the distance between the end portion of one end of the heat absorption hollow cylinder close to the substrate 700 and the substrate 700 is 20 mm-100 mm, so that the temperature gradient (the axial temperature gradient of the chamber) above the substrate 700 can be reduced, and the growth condition of the substrate is more stable, thereby improving the thickness uniformity and doping uniformity. Preferably, the distance between the end portion of one end of the heat absorption hollow cylinder close to the substrate 700 and the substrate 700 is 50 mm. However, the present invention is not limited thereto.

In this embodiment, the connecting member 510 is disposed at a top position of the heat absorption hollow cylinder. The annular portion 511, the connecting bars 512 and the heat absorption hollow cylinder may be integrally provided. In another embodiment, the annular portion, the connecting bars and the heat absorption hollow cylinder may also be manufactured separately and then connected and fixed in a mechanical or welding manner. The present invention does not limit a connection manner thereof.

In the present invention, the number of the connecting bars 512 is three, and the three connecting bars are disposed in central symmetry. Alternatively, as shown in FIG. 6, the number of the connecting bars 512 is four, and the four connecting bars 512 are disposed in central symmetry. It can be understood that the number of the connecting bars 512 is not limited thereto. Alternatively, the number of the connecting bars 512 may be greater than or equal to 2, as long as the heat absorption hollow cylinder can be fixed without affecting the uniformity of the reaction gas transmitted to the surface of the substrate. In this embodiment, this will facilitate replacing the temperature control component 500.

In this embodiment, the heat absorption hollow cylinder can heat the reaction gas flowing through the interior thereof and can also heat the reaction gas flowing across an outer surface of the heat absorption hollow cylinder, realizing the purpose of reducing the radial temperature gradient of the chamber (which specifically refers to the chamber liner).

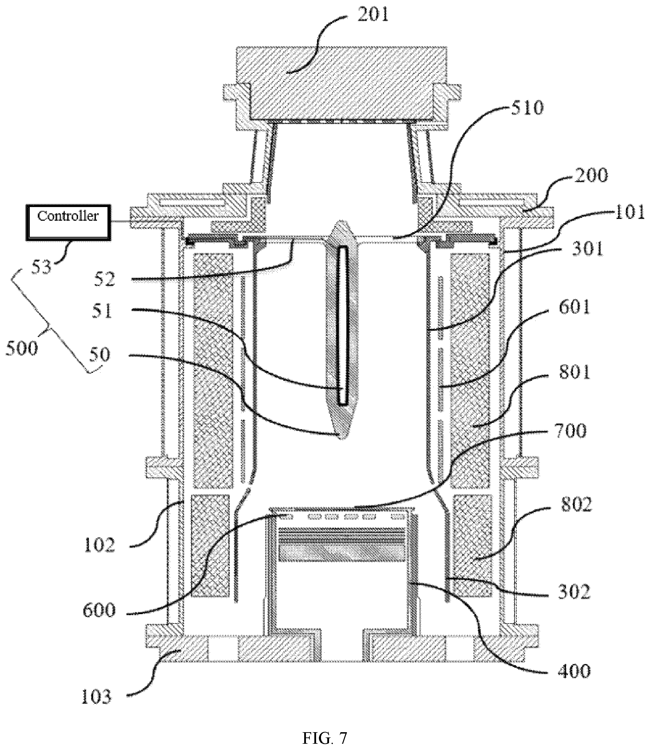

As shown in FIG. 7, in this embodiment and other embodiments, the temperature control component 500 may also include: a heater 51 provided inside a heating main body 50 (it can be understood that the heating main body may be a heating rod in the shape of a spindle body and may also be a cylindrical heating hollow cylinder); and a controller 53 located outside the chamber and connected to the heater 51, wherein the controller 53 controls the heater 51 to heat the central area of the chamber (which specifically refers to the chamber liner). The heater 51 includes a plurality of heating wires 52, wherein the heating wires 52 may penetrate through the connecting member 510 and are led to the outside of the chamber and connected to the controller 53. Accordingly, the heater 51 can be adjusted and controlled via the controller 53 to actively heat the reaction gas in the central area of the chamber (which specifically refers to the chamber liner) at a preset temperature, so that the radial temperature gradient along the radial direction inside the chamber (which specifically refers to the chamber liner) is reduced better, and the problem that the gas in the area close to the side heater has a higher temperature and is likely to flow upward, and the gas in the central area has a lower temperature and is likely to flow downward to form a gas vortex above the substrate is solved, thereby reducing by-product deposition on the side walls of the upper liner and the lower liner and shower head fittings, increasing the utilization rate of the reaction gas source, and prolonging the maintenance period of the side walls of the upper liner and the lower liner and the shower head. The temperature control component 500 can also reduce the temperature gradient above the substrate, so that the growth condition of the substrate is more stable, thereby improving the thickness uniformity and doping uniformity.

It should be noted that relational terms herein such as first, second and so on are only used to distinguish one entity or operation from another entities or operations, and do not necessarily require or imply that there is any such actual relationship or order between these entities or operations. Furthermore, the terms "comprise", "include" or any other variant thereof are intended to cover non-exclusive inclusion, so that a process, method, object or equipment including a series of elements not only includes those elements, but also includes other elements not explicitly listed, or also includes elements inherent to such process, method, object or equipment. Without further limitations, an element defined by the phrase "comprising a ..." does not exclude the presence of additional identical elements in the process, method, object or equipment including the element.

In the description of the present invention, it should be understood that the terms "center", "height", "thickness", "upper", "lower", "vertical", "horizontal", "top", "bottom", "inside", "outside", "axial", "radial", "circumferential" and other directions or positional relationships indicated are those based on the directions or positional relationships shown in the drawings, only for the convenience of describing the present invention and simplifying the description, instead of indicating or implying that the equipment or element referred to must have a specific orientation and be constructed and operated in a specific orientation, so they cannot be interpreted as limitations to the present invention. In the description of the present invention, unless otherwise specified, "plurality" means two or more.

In the description of the present invention, unless otherwise specified and defined explicitly, such terms as "mount" "link", "connect" and "fix" should be understood in a broad sense. For example, the connection may refer to a fixed connection, a detachable connection, or an integrated connection, may also refer to a mechanical connection or an electric connection, may also refer to a direct connection or an indirect connection by an intermediary medium and may even refer to internal communication between two elements or interaction between two elements. Those of ordinary skill in the art can understand the specific meanings of the above terms in the present invention in light of specific circumstances.

In the present invention, unless otherwise specified and defined explicitly, if a first feature is "above" or "below" a second one, this may cover the direct contact between the first and second features, and also cover the contact via another feature therebetween, instead of the direct contact. Furthermore, if the first feature is "above", "over" or "on the top of" a second one, this may cover that the first feature is right above or obliquely above the second feature, or just indicate that the first feature has a horizontal height higher than that of the second feature. If the first feature is "under", "below" and "beneath" the second feature, this may cover that the first feature is right below and obliquely below the second feature, or just indicate that the first feature has a horizontal height lower than that of the second feature.

Although the content of the present invention has been described in detail through the above preferred embodiments, it should be understood that the above description should not be considered as limitations to the present invention. Various modifications and alternatives to the present invention will become apparent to those skilled in the art upon reading the foregoing contents. Accordingly, the scope of protection of the present invention shall be limited by the appended claims.

## Claims

1. A chemical vapor deposition (CVD) reaction apparatus, comprising: a chamber;
a shower head (201) provided at the top of the chamber and configured to introduce a reaction gas for growing a thin film into the chamber; and
a susceptor(400) provided at the bottom of the chamber, disposed opposite to the shower head (201) and configured to carry a substrate (700), wherein the chamber further comprises:
a liner located inside the chamber and disposed around an inner side wall of the chamber;
a side heater (601) provided close to the inner side wall of the chamber, located above the susceptor(400) and configured to heat the reaction gas in the chamber; and
a temperature control component (500) provided inside the chamber and located above the susceptor(400), the temperature control component (500) emitting heat to heat the reaction gas in a central area of the chamber.

2. The CVD reaction apparatus according to claim 1, wherein the temperature control component (500) is coaxially arranged with the chamber, and a lengthwise annular gas flow passage is formed between an outer side wall of the temperature control component (500) and the liner.

3. The CVD reaction apparatus according to claim 1, wherein the temperature control component (500) is fixedly connected to the chamber via a connecting member (510), and the connecting member (510) is located at one end of the temperature control component (500) close to the shower head (201).

4. The CVD reaction apparatus according to claim 3, wherein the liner comprises an upper liner (301) and a lower liner (302), the lower liner (302) is provided at the periphery of the susceptor(400), the upper liner (301) is located above the lower liner (302), and the side heater (601) is located between the upper liner (301) and the inner side wall of the chamber; and
the temperature control component (500) is connected to the upper liner (301) via the connecting member (510).

5. The CVD reaction apparatus according to claim 4, wherein the connecting member (510) comprises an annular portion (511) and a plurality of connecting bars (512), and the plurality of connecting bars (512) are provided at intervals around the temperature control component (500); one end of each of the connecting bars (512) is connected to the temperature control component (500), and the other end of each of the connecting bars is connected to the annular portion (511); and the annular portion (511) laps over the upper liner (301).

6. The CVD reaction apparatus according to claim 5, wherein the annular portion (511), the plurality of connecting bars (512) and the temperature control component (500) are integrally provided.

7. The CVD reaction apparatus according to claim 1, further comprising a lower heater (600) provided inside the susceptor(400) and configured to heat the substrate (700).

8. The CVD reaction apparatus according to any one of claims 1-7, wherein the heat absorption rate of the temperature control component (500) is greater than the heat absorption rate of the reaction gas.

9. The CVD reaction apparatus according to any one of claims 3-7, wherein the temperature control component (500) and the connecting member (510) are prepared from at least one material selected from graphite, silicon carbide, tantalum carbide or high-temperature-resistant metals such as tungsten, molybdenum, tantalum, etc.

10. The CVD reaction apparatus according to any one of claims 3-7, wherein silicon carbide and/or tantalum carbide coatings are provided on surfaces of the temperature control component (500) and the connecting member (510).

11. The CVD reaction apparatus according to claim 8, wherein the temperature control component (500) is a heat absorption rod and extends along an axial direction of the chamber; and the heat absorption rod is configured to absorb heat emitted by the lower heater (600) and the side heater (601) and emit the absorbed heat to the central area of the chamber to heat the reaction gas located in the central area of the chamber.

12. The CVD reaction apparatus according to claim 11, wherein the heat absorption rod is integrally in the shape of a spindle body.

13. The CVD reaction apparatus according to claim 11, wherein the diameter of the heat absorption rod is less than 1/2 of the diameter of the substrate (700).

14. The CVD reaction apparatus according to claim 11, wherein the length of the heat absorption rod is greater than 1/2 of the length of the liner (301).

15. The CVD reaction apparatus according to claim 11, wherein the distance between an end portion of one end of the heat absorption rod close to the substrate (700) and the substrate (700) is 20 mm-100 mm.

16. The CVD reaction apparatus according to claim 8, wherein the temperature control component (500) is a heat absorption hollow cylinder and extends along the axial direction of the chamber; and the heat absorption hollow cylinder is configured to absorb heat emitted by the lower heater (600) and the side heater (601) and emit the absorbed heat to the central area of the chamber to heat the reaction gas located in the central area of the chamber.

17. The CVD reaction apparatus according to claim 16, wherein the diameter of the heat absorption hollow cylinder is greater than the diameter of the substrate (700) and smaller than the inner diameter of the liner (301).

18. The CVD reaction apparatus according to claim 16, wherein the length of the heat absorption hollow cylinder is greater than 1/2 of the length of the liner (301).

19. The CVD reaction apparatus according to claim 16, wherein the distance between an end portion of one end of the heat absorption hollow cylinder close to the substrate (700) and the substrate (700) is 20 mm-100 mm.

20. The CVD reaction apparatus according to claim 10, wherein the temperature control component (500) comprises: a heating main body (50);
a heater (51) provided inside the heating main body (50); and
a controller (53) located outside the chamber and connected to the heater (51), wherein
the controller (53) controls the heater (51) to heat the central area of the chamber.

21. The CVD reaction apparatus according to claim 20, wherein the heater (51) comprises a heating wire (52) which penetrates through the connecting member (510) and is led to the outside of the chamber.

22. The CVD reaction apparatus according to claim 1, further comprising a top cover (200), wherein the top cover is provided at the top of the chamber, and the shower head (201) is provided on the top cover (200).

23. A temperature control component applied in a chamber of a CVD reaction apparatus, wherein the temperature control component comprises a heating main body and a connecting member, the heating main body is provided inside the chamber and configured to heat a reaction gas in a central area of the chamber, and the connecting member is configured to implement a connection between the heating main body and the chamber.

24. The temperature control component according to claim 23, wherein the heating main body is coaxially arranged with the chamber.

25. The temperature control component according to claim 24, wherein the connecting member comprises an annular portion and a plurality of connecting bars, and the plurality of connecting bars are provided at intervals around the heating main body; one end of each of the connecting bars is connected to the heating main body, and the other end of each of the connecting bars is connected to the annular portion; and the annular portion is fixedly connected to the chamber.

26. The temperature control component according to claim 25, wherein the heating main body is a heat absorption rod and extends along an axial direction of the chamber; and the heat absorption rod is configured to absorb heat emitted by a lower heater and a side heater both provided in the CVD reaction apparatus and emit the absorbed heat to the central area of the chamber to heat the reaction gas located in the central area of the chamber.

27. The temperature control component according to claim 26, wherein the heat absorption rod is integrally in the shape of a spindle body.

28. The temperature control component according to claim 25, wherein the heating main body is a heat absorption hollow cylinder and extends along the axial direction of the chamber; and the heat absorption hollow cylinder is configured to absorb heat emitted by the lower heater and the side heater both provided in the CVD reaction apparatus and emit the absorbed heat to the central area of the chamber to heat the reaction gas located in the central area of the chamber.

29. The temperature control component according to claim 28, wherein the diameter of the heat absorption hollow cylinder is greater than or equal to the diameter of a substrate processed in the CVD reaction apparatus.

30. The temperature control component according to claim 23, wherein the heat absorption rate of the heating main body is greater than the heat absorption rate of the reaction gas.

31. The temperature control component according to claim 25, wherein the heating main body and the connecting member are prepared from at least one material selected from graphite, silicon carbide, tantalum carbide or high-temperature-resistant metals such as tungsten, molybdenum, tantalum, etc.

32. The temperature control component according to claim 25, wherein silicon carbide and/or tantalum carbide coatings are provided on surfaces of the heating main body and the connecting member.

33. The temperature control component according to claim 26, further comprising: a heater provided inside the heating main body; and a controller located outside the chamber and connected to the heater, wherein the controller controls the heater to heat the central area of the chamber.
